**Europäisches Patentamt**

**European Patent Office**

**Office européen des brevets**

(19)

(11) Veröffentlichungsnummer: **0 183 936**

**A1**

(12) # EUROPÄISCHE PATENTANMELDUNG

(21) Anmeldenummer: **85112266.3**

(22) Anmeldetag: **27.09.85**

(51) Int. Cl.⁴: **H 05 K 3/46**

(30) Priorität: **28.11.84 CH 5674/84**

(43) Veröffentlichungstag der Anmeldung:
**11.06.86 Patentblatt 86/24**

(84) Benannte Vertragsstaaten:
**CH DE FR GB IT LI NL SE**

(71) Anmelder: **CONTRAVES AG**
**Schaffhauserstrasse 580**
**CH-8052 Zürich(CH)**

(72) Erfinder: **Elsener, Josef**
**Anton Higistrasse 8**
**CH-8046 Zürich(CH)**

(54) **Multisubstrat-Schaltungsanordnung und Verfahren zur Herstellung der elektrischer Verbindungen.**

(57) Es wird eine Multisubstrat-Schaltungsanordnung (Multilayer) und ein Verfahren zur Herstellung derselben und deren elektrischen Verbindungen vorgeschlagen, welche Anordnung im wesentlichen dreilagig ausgebildet ist und ein erstes, doppelseitig metallisiertes Trägerelement (10), ein zweites, einseitig metallisiertes Trägerelement (20) sowie eine dazwischen angeordnete Isolierung (30) umfasst.

Aus der Metallschicht der Zwischenebene (B) werden Leiterbahnen (31 bis 37) geätzt, danach die Elemente (10, 20, 30) zu einer Baueinheit zusammengepresst und anschliessend an programmartig vorbestimmten Stellen ausgehend von einer Bestückungsebene (A) mit einem ersten Bohrdatensatz erste Löcher (1', 3", 4', 6", 7') und bei oberflächenseitig gewendeter Baueinheit, ausgehend von einer Unterebene (C) an programmartig vorbestimmten Stellen mit einem zweiten, spiegelbildlichen Bohrdatensatz zweite Löcher (2', 3", 5', 6") gebohrt.

Nach dem Metallisieren sämtlicher Löcher werden an der Bestückungsebene (A) Kontakt- uhnd Leiterflächen (22 bis 28) und an der Unterebene (C) entsprechende Leiterbahnen (13 bis 18) hergestellt.

FIG. 1

EP 0 183 936 A1

## Multisubstrat-Schaltungsanordnung und Verfahren zur Herstellung der elektrischen Verbindungen

Die Erfindung betrifft eine Multisubstrat-Schaltungsanordnung sowie ein Verfahren zur Herstellung der elektrischen Verbindungen zwischen den einzelnen, auf gegeneinander isolierten und zusammengepressten Trägerelementen aufgebrachten Metallschichten, die durch Aetzung in Kontaktflächen und/oder Leiterbahnen unterteilbar sind.

Aus der DE-PS 21 03 767 ist eine aus einer Vielzahl gestapelter und gedruckter Schaltungsplatten gebildete Anordnung sowie ein Verfahren zum Verbinden der einzelnen Schaltungsplatten bekannt. Die Schaltungsplatten sind jeweils durch eine isolierende Lage voneinander getrennt, wobei durch das gesamte Lagenpaket oder aber nur durch einzelne Platten entsprechende Oeffnungen hindurchgehen, in welche Oeffnungen mit einem Lot überzogene Spiralfedern eingeführt werden. Diese Multilayer-Anordnung behandelt lediglich ein durch die Erwärmung des auf die Federn aufgebrachten Lotes erreichbares elektrischen Verbinden der einzelnen Schaltungsplatten untereinander.

Der Erfindung liegt die Aufgabe zugrunde, eine Multisubstratschaltungsanordnung sowie ein Verfahren zur Herstellung derselben und der elektrischen Verbindungen anzugeben, bei welcher eine Reduktion der Anzahl Substratträgerelemente und gleichzeitig eine kleinere Baueinheit unter Beibehaltung einer relativ hohen Anschlussdichte (Packungsdichte) auf engstem Raum erreicht wird.

Hinsichtlich der Schaltungsanordnung wird die Aufgabe dadurch gelöst, dass die Anordnung als dreilagig zusammengepresstes Multisubstrat (Multilayer) mit einer Bestückungsebene, einer Zwischenebene und einer Unterebene ausgebildet ist und ein erstes, doppelseitig metallisiertes Trägerelement sowie ein zweites, einseitig metallisiertes Trägerelement und eine zwischen den beiden Trägerelementen angeordnete Isolierung (Prepreg) umfasst, wobei einerseits die freiliegenden Metallschichten der Bestückungsebene sowie der Unterebene mit der eingeklemmten Metallschicht durch metallisierte Sacklöcher und andererseits die freiliegenden Metallschichten der Bestückungs- und Unterebene durch metallisierte Durchgangslöcher elektrisch wirkverbunden sind.

Die Aufgabe hinsichtlich des Verfahrens zur Herstellung der elektrischen Verbindungen wird gemäss der Erfindung dadurch gelöst, dass

a) nach dem Aetzen der Leiterbahnen aus der Metallschicht der Zwischenebene und dem Verpressen der einzelnen Elemente zu einer Baueinheit, an programmartig vorbestimmten Stellen zwischen der Metallschicht der Bestückungsebene und den Leiterbahnen der Zwischenebene mit einem ersten Bohrdatensatz (CAD-Daten) eine erste Anzahl Löcher, und

b) bei gewendeter Baueinheit an programmartig vorbestimmten Stellen zwischen der Unterebene und den jeweiligen Leiterbahnen der Zwischenebene mit einem zweiten, gespiegelten Bohrdatensatz (CAD-Daten) eine zweite Anzahl Löcher gebohrt werden,

c) die Löcher zur elektrischen Verbindung der einzelnen Ebenen untereinander metallisiert werden, und

d) durch Aetzung an der Bestückungsebene im Abstand zueinander angeordnete Kontakt- und Leiterflächen und an der Unterebene entsprechend angeordnete Leiterbahnen hergestellt werden.

Weitere Merkmale der Erfindung ergeben sich aus der folgenden Beschreibung in Verbindung mit der Zeichnung und den Patentansprüchen.

Die Erfindung wird nachstehend anhand der Zeichnung näher beschrieben. Es zeigt:

Fig.1 eine in grösserem Massstab und im Schnitt dargestellte Ausführungsform einer Multisubstrat-Schaltungsanordnung, und

Fig.2 die schematisch dargestellte Schaltungsanordnung gemäss Fig.1 als perspektivische Sprengansicht.

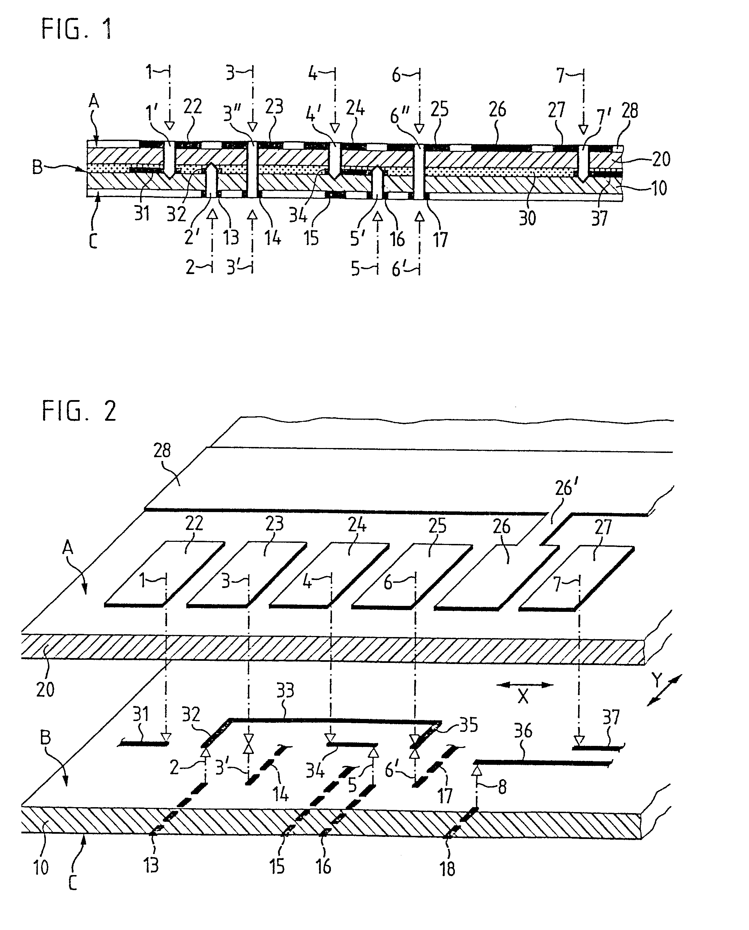

In Fig.1 ist im Schnitt ein Ausführungsbeispiel einer dreilagig gestapelten Multisubstrat-Schaltungsanordnung dargestellt, welche im wesentlichen ein erstes, als Trägerelement vorgesehenes Substrat 10 sowie ein zweites, ebenfalls als Trägerelement vorgesehenes Substrat 20 umfasst. Zwischen den beiden Substraten 10,20 ist ein als Kleber und Ioslator verwendbarer Prepreg 30 vorgesehen. Das erste Substrat 10 ist beidseitig mit einer nicht näher bezeichneten Metallschicht versehen, welche jeweils nach dem an sich bekannten photolitographischen Verfahren der Halbleitertechnik in einzelne Leiterbahnen geätzt wird. Das zweite Substrat 20 ist einseitig mit einer nicht näher bezeichneten Metallschicht versehen, welche ebenfalls, wie vorstehend beschrieben, durch Aetzung in einzelne Kontaktflächen oder Leiterbahnen unterteilt wird.

In Fig.2 ist die Schaltungsanordnung ohne Isolierung 30 (Prepreg) als perspektivische Sprengansicht dargestellt und man erkennt das zweite Substrat 20 mit mehreren aus der nicht bezeichneten Metallschicht geätzten Kontaktflächen 22,23,24,25,26,26' und 27 sowie eine als Leiterbahn 28 ausgebildete elektrische Speisung, welche über den Steg 26' mit der Kontaktfläche 26 elektrisch verbunden ist. Weiterhin erkennt man das erste Substrat 10, welches auf der dem zweiten Substrat 20 zugewandten Seite mit aus der einen Metallschicht gebildeten Leiterbahnen 31,32,33,34,35,36 und 37 und auf der dem zweiten Substrat 20 abgewandten Seite mit aus der anderen Metallschicht geätzten Leiterbahnen 13,14,15,16,17 und 18 versehen ist. Die auf der dem zweiten Substrat 20 zugewandten Seite vorgesehenen Leiterbahnen 31 bis 37 können im wesentlichen in X- und/oder Y-Richtung orientiert sein, während die an der Unterseite des ersten Substrats 10 angeordneten Leiterbahnen 13-18 im wesentlichen in Y-Richtung orientiert sind.

Die an dem ersten Substrat 10 vorgesehenen Leiterbahnen 13 bis 18 sowie 31 bis 37 sowie die an dem zweiten Substrat 20 vorgesehenen Kontaktflächen 22 bis 27 und die Speisung 28 werden nach vorbestimmtem Programm aus den jeweiligen Metallschichten geätzt. Die Metallschichten bestehen beispielsweise aus einer aufgebrachten Kupferfolie oder aus einer aufgedampften beziehungsweise aufgestäubten Kufperschicht oder dergleichen.

In der vorstehend beschriebenen Schaltungsanordnung muss die elektrische Kontaktierung nicht nur zwischen den Kontaktflächen 22 bis 27 der mit Pfeilrichtung A bezeichneten Bestückungsebene und den in X- und/oder Y-Richtung orientierten Leiterbahnen 31 bis 37 der mit Pfeilrichtung B bezeichneten Zwischenebene hergestellt werden, sondern auch, wie in Fig.1 und Fig.2 dargestellt, zwischen den Kontaktflächen 22 bis 27 der Bestückungsebne A, den Leiterbahnen 31 bis 37 der Zwischenebene B und den an der mit Pfeilrichtung C bezeichneten Unterseite des ersten Substrates in Y-Richtung orientierten Leiterbahnen 13 bis 18 hergestellt werden, wobei die Kontaktflächen 22 bis 27, die Leiterbahnen 31 bis 37 sowie die Leiterbahnen 13 bis 18 hierbei in X- und/oder Y-Richtung versetzt zueinander angeordnet sein können. Dies wird gemäss einem ersten Verfahrensschritt im wesentlichen dadurch erreicht, dass nach dem Aetzen der Leiterbahnen 31 bis 37 in der Zwischenebene B und dem Verpressen der einzelnen Elemente 10,20 und 30 zu einer Baueinheit, an programmartig vorbestimmten Stellen, an denen eine elektrische Verbindung zwischen der Metallschicht der Bestückungsebene A und den jeweiligen Leiterbahnen der Zwischenebene B hergestellt werden soll, mit einem ersten Bohrdatensatz (CAD-Daten) in Pfeilrichtung 1,3,4,6 und 7 eine erste Anzahl Löcher 1', 3",4',6' und 7' gebohrt werden.

Nach einem zweiten Verfahrensschritt wird die Baueinheit oberflächenseitig derart gewendet und positioniert, dass an programmartig vorbestimmten Stellen, an denen eine elektrische Verbindung zwischen der Metallschicht der Unterebene C und den jeweiligen Leiterbahnen der Zwischenebene B hergestellt werden soll, mit einem zweiten, gespiegelten Bohrdatensatz (CAD-Daten) in Pfeilrichtung 2,3',5' und 6' eine zweite Anzahl Löcher 2',3",5' und 6" gebohrt werden kann. Wie in Fig.1 dargestellt, sind die Löcher 1',2',4',5' und 7' hierbei als Sacklöcher und durch das doppelseitige Bohrverfahren die Löcher 3" und 5" als Durchgangslöcher ausgebildet.

Nach einem dritten Verfahrensschritt werden sämtliche Löcher 1',2',3",4',5',6" und 7' metallisiert, wodurch eine elektrische Verbindung mit den Metallschichten der einzelnen Ebenen A,B und C erreicht wird.

Nach einem weiteren Verfahrensschritt werden nunmehr durch Aetzung an der Bestückungsebene A die Kontaktflächen 22 bis 27 sowie die Speisung 28 und an der Unterebene C die in Y-Richtung orientierten Leiterbahnen 13 bis 18 hergestellt.

0183936

Patentansprüche:

1. Multisubstrat-Schaltungsanordnung zwischen den einzelnen, auf gegeneinander isolierten und zusammengepressten Trägerelementen aufgebrachten Metallschichten, die durch Aetzung in Kontaktflächen und/oder Leiterbahnen unterteilbar sind, dadurch gekennzeichnet, dass die Anordnung als dreilagig zusammengepresstes Multisubstrat (Multilayer) mit einer Bestückungsebene (A), einer Zwischenebene (B) und einer Unterebene (C) ausgebildet ist und ein erstes, doppelseitig metallisiertes Trägerelement (10) sowie ein zweites, einseitig metallisiertes Trägerelement (20) und eine zwischen den beiden Trägerelementen angeordnete Isolierung (30) umfasst, wobei einerseits die freiliegenden Metallschichten der Bestückungsebene (A) sowie der Unterebene (C) mit der eingeklemmten Metallschicht durch metallisierte Sacklöcher (1',2', 4',5',7') und andererseits die freiliegenden Metallschichten der Bestückungs- und Unterebene durch metallisierte Durchgangslöcher (3",6") elektrisch wirkverbunden sind.

2. Schaltungsanordnung nach Anspruch 1, dadurch gekennzeichnet, dass die Bestückungsebene (A) mit einer Anzahl Kontaktflächen (22,23,24,25,26,27) und einer Speisung (28), die Zwischenebene (B) mit einer in X- und/oder Y-Richtung orientierten Anzahl Leiterbahnen (31,32,33,34,35,36,37) und die Unterebene (C) mit einer in Y-Richtung orientierten Anzahl Leiterbahnen (13,14,15,16,17) versehen ist.

3. Schaltungsanordnung nach Anspruch 1, dadurch gekennzeinet, dass die aus den einzelnen Trägerelementen (10,20) und der Isolierung (30) bestehende Anordnung ·als eine Baueinheit ausgebildet ist.

4. Verfahren zur Herstellung der Multisubstrat-Schaltungsanordnung und deren elektrischen Verbindungen, dadurch gekennzeichnet, dass

a) nach dem Aetzen der Leiterbahnen (31 bis 37) aus der Metallschicht der Zwischenebene (B) und dem Pressen der einzelnen Elemente (10,20,30) zu einer Baueinheit, an programmartig vorbestimmten Stellen zwischen der Metallschicht der Bestückungsebene (A) und den Leiterbahnen (31 bis 37) der Zwischenebene (B) mit einem ersten Bohrdatensatz (CAD-Daten) eine erste Anzahl Löcher (1',3",4',6",7'), und

b) bei gewendeter Baueinheit an programmartig vorbestimmten Stellen zwischen der Unterebene (C) und den jeweiligen Leiterbahnen (31 bis 37) der Zwischenebene (B) mit einem zweiten, gespiegelten Bohrdatensatz (CAD-Daten) eine zweite Anzahl Löcher (2',3",5',6") gebohrt werden,

c) die Löcher (1',2',3",4',5',6",7') zur elektrischen Verbindung der einzelnen Ebenen (A,B,C) untereinander metallisiert werden, und

d) durch Aetzung an der Bestückungsebene (A) die im Abstand zueinander angeordneten Kontakt- und Leiterflächen (22 bis 28) und an der Unterebene (C) die entsprechend angeordneten Leiterbahnen (13 bis 18) hergestellt werden.

0183936

## FIG. 1

## FIG. 2

**0183936**
Nummer der Anmeldung

EP 85 11 2266

**Europäisches Patentamt**

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | US-A-3 649 475 (GENERAL DYNAMICS CORP.) * Spalte 2, Zeilen 30-51; Spalte 3, Zeile 24 - Spalte 6, Zeile 65; Figuren * | 1-3 | H 05 K 3/46 |
| A | | 4 | |
| | --- | | |
| Y | DE-A-2 333 383 (SALMINEN AARNE) * Seite 4, Absatz 3 * | 1-3 | |
| | --- | | |
| A | DE-A-2 053 221 (STANDARD ELEKTRIK LORENZ A.G.) | | |
| | --- | | |
| A | US-A-3 898 370 (COMPAGNIE HONEYWELL BULL) | | |
| | ----- | | |

RECHERCHIERTE SACHGEBIETE (Int Cl 4)

H 05 K

Der vorliegende Recherchenbericht wurde für alle Patentansprüche erstellt

| Recherchenort DEN HAAG | Abschlußdatum der Recherche 27-02-1986 | Prüfer SCHUERMANS N.F.G. |
|---|---|---|